# DEMANDE DE BREVET EUROPEEN

(11) **EP 4 280 261 A1**
(43) Date de publication de la demande: **22.11.2023**
(21) Numéro de dépôt: 23172351.1
(22) Date de dépôt: 09.05.2023
(51) Int. Cl.: H01L 21/683, B32B 7/12, C09J 5/06, B32B 17/06

(54) **PROCEDE DE COLLAGE TEMPORAIRE**

(30) Priorité: 17.05.2022 FR 2204676
(71) Demandeur: Commissariat à l'énergie atomique et aux énergies alternatives, 75015 Paris (FR)
(72) Inventeur: MONTMEAT, Pierre, 38054 GRENOBLE CEDEX 09 (FR); FOURNEL, Frank, 38054 GRENOBLE CEDEX 09 (FR)
(74) Mandataire: Brevalex

(57) **Abrégé**

Procédé de collage temporaire comprenant les étapes suivantes :
a) fournir un empilement comprenant successivement un substrat d'intérêt (100), un adhésif thermoplastique (150), et un premier substrat temporaire (200),
b) positionner un deuxième substrat temporaire (300) sur le substrat d'intérêt (100), le premier substrat temporaire (200) et le deuxième substrat temporaire (300) ayant chacun une surface supérieure à la surface du substrat d'intérêt (100),
c) appliquer un traitement thermique à une température supérieure ou égale à la température de transition vitreuse de l'adhésif thermoplastique (150), moyennant quoi l'adhésif thermoplastique (150) forme une bande latérale autour du substrat d'intérêt (100) et adhère au premier substrat temporaire (200) et au deuxième substrat temporaire (300),
d) retirer le deuxième substrat temporaire (300),
e) fixer le substrat d'intérêt (100) sur un cadre (400), au moyen d'une feuille adhésive (401),
f) retirer le premier substrat temporaire (200) et l'adhésif thermoplastique (150).

## Description

### DOMAINE TECHNIQUE

La présente invention se rapporte au domaine général des transferts de films.

L'invention concerne un procédé de collage temporaire.

L'invention concerne également une structure comprenant un substrat d'intérêt et un substrat temporaire.

L'invention est particulièrement intéressante puisqu'elle permet de séparer facilement le substrat temporaire (poignée) du substrat d'intérêt aminci.

L'invention trouve des applications dans de nombreux domaines industriels, et notamment pour la fabrication d'imageurs, de microphones ou de systèmes microélectromécaniques (ou MEMs pour 'MicroElectroMechanical Systems').

### ÉTAT DE LA TECHNIQUE ANTÉRIEURE

Actuellement, l'élaboration de circuits sur des plaques amincies passe généralement par un procédé de collage temporaire dans lequel on utilise une poignée temporaire pour amincir puis manipuler la plaque amincie.

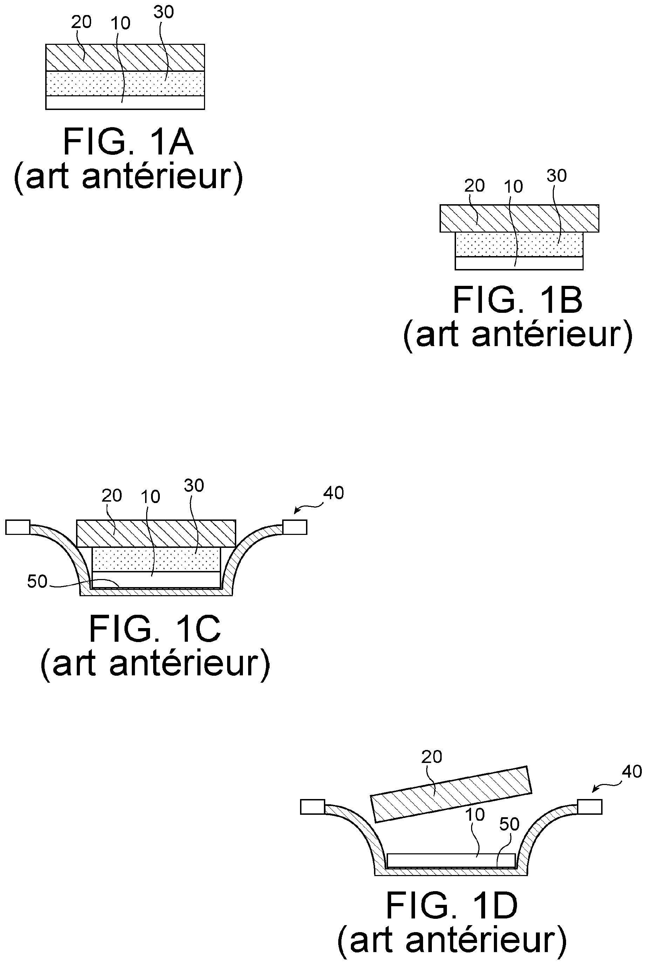

Classiquement, le procédé de collage temporaire comprend les étapes suivantes :
- coller un substrat d'intérêt 10 sur un substrat temporaire 20 (aussi appelé poignée ou plaque poignée) au moyen d'un adhésif 30 (figure 1A),
- amincir et détourer le substrat d'intérêt 10 à la géométrie voulue et réaliser des étapes technologiques sur la face du substrat temporaire 10 accessible (figure 1B),
- monter l'assemblage ainsi obtenu sur un cadre 40 au moyen d'une feuille adhésive 50 (figure 1C),
- retirer le substrat temporaire 20 et l'adhésif 30 (figure 1D).

La feuille adhésive 50 utilisée pour le montage sur le cadre 40 est généralement très flexible et peut contacter le substrat temporaire 20 au niveau du détourage du substrat d'intérêt 10 (comme représenté sur la figure 1C). Ce phénomène est d'autant plus accentué que l'épaisseur du substrat d'intérêt 10 est faible (typiquement inférieure à 200 µm) et le détourage est large (typiquement supérieur à 0,5 µm).

Le démontage du substrat temporaire 20 devient alors très difficile, voire impossible, à cause de la présence de ces zones de contact. Il est donc nécessaire de fournir un effort mécanique de démontage très important pour pouvoir retirer le substrat temporaire 20, ce qui peut endommager le substrat d'intérêt 10.

Actuellement, il n'existe pas de solutions pour remédier à ce problème.

### EXPOSÉ DE L'INVENTION

Un but de la présente invention est de proposer un procédé de collage temporaire remédiant aux inconvénients de l'art antérieur, et en particulier, permettant de retirer facilement le substrat temporaire sans endommager le substrat d'intérêt.

Pour cela, la présente invention propose un procédé de collage temporaire comprenant les étapes suivantes :
a) fournir un empilement comprenant successivement :
   - un substrat d'intérêt, ayant une première face principale et une deuxième face principale,
   - un adhésif thermoplastique, en regard de la première face principale du substrat d'intérêt,
   - un premier substrat temporaire,
b) positionner un deuxième substrat temporaire sur la deuxième face principale du substrat d'intérêt, le premier substrat temporaire et le deuxième substrat temporaire ayant chacun une surface supérieure à la surface du substrat d'intérêt,
c) appliquer un traitement thermique à une température supérieure ou égale à la température de transition vitreuse de l'adhésif thermoplastique, et éventuellement appliquer une force, moyennant quoi l'adhésif thermoplastique forme une bande latérale autour du substrat d'intérêt et adhère à la fois au premier substrat temporaire et au deuxième substrat temporaire,
d) retirer le deuxième substrat temporaire,
e) fixer le substrat d'intérêt sur un cadre, au moyen d'une feuille adhésive, la feuille adhésive étant en contact avec la première face principale du substrat d'intérêt,
f) retirer le premier substrat temporaire et l'adhésif thermoplastique.

L'invention se distingue fondamentalement de l'art antérieur par la formation d'une bande latérale adhésive autour du substrat d'intérêt. Cette bande latérale évite le contact entre la feuille adhésif fixée au cadre et le premier substrat temporaire (i.e. la poignée) qui peut donc être retiré facilement, sans avoir besoin de mettre en oeuvre un effort mécanique de démontage important. Le substrat d'intérêt est ainsi préserver, même pour des substrats de très faibles épaisseurs (typiquement inférieure à 200 µm) et/ou pour un détourage important (typiquement supérieur à 500 µm).

La formation de la bande latérale autour du substrat d'intérêt est rendue possible grâce à l'utilisation d'un premier substrat temporaire et d'un deuxième substrat temporaire ayant chacun une surface supérieure à celle du substrat d'intérêt.

Lors de l'étape c) on chauffe l'adhésif thermoplastique à une température supérieure à sa température de transition vitreuse moyennant quoi l'adhésif thermoplastique devient visqueux et coule de part et d'autre du substrat d'intérêt jusqu'à contacter à la fois premier substrat temporaire et le deuxième substrat temporaire, formant ainsi une bande latérale adhésive autour du substrat d'intérêt. L'application d'une pression facilite la formation de cette bande latérale.

Selon une première variante de réalisation avantageuse, la température de transition vitreuse de l'adhésif thermoplastique est inférieure à 250°C, et de préférence inférieure à 200°C.

Avantageusement, selon cette première variante de réalisation, le deuxième substrat temporaire est en polytétrafluoroéthylène ou en polyimide. Alternativement, le deuxième substrat peut être recouvert d'une couche polymère de polytétrafluoroéthylène ou de polyimide. La couche de polymère est positionnée entre le deuxième substrat temporaire et le substrat d'intérêt.

Avantageusement, selon cette première variante de réalisation, l'étape d) est réalisée par une action mécanique, et le cas échéant la couche de polymère recouvrant le deuxième substrat temporaire est retirée par pelage.

Avantageusement, selon cette première variante de réalisation, lors de l'étape c), on applique une thermocompression.

Selon une deuxième variante de réalisation avantageuse, la température de transition vitreuse de l'adhésif thermoplastique est supérieure à 200°C, de préférence supérieure à 250°C et l'étape b), est, de préférence, réalisée par collage direct.

Avantageusement, selon cette deuxième variante de réalisation, l'étape d) est réalisée par rodage mécanique et attaque chimique.

Avantageusement, selon cette deuxième variante de réalisation, lors de l'étape c), on applique une thermocompression.

Selon une troisième variante de réalisation avantageuse, on peut envisager un démontage du second substrat par laser. Dans ce cas, le deuxième substrat temporaire est, de préférence, en verre ou en silicium et il est recouvert par une couche de démontage sensible au laser, par exemple au rayonnement UV ou infra-rouge. La couche de démontage sensible au laser est positionnée entre le deuxième substrat temporaire et le substrat d'intérêt.

Avantageusement, selon cette troisième variante de réalisation, lors de l'étape c), on applique une thermocompression.

Avantageusement, selon cette troisième variante de réalisation, l'étape d) est réalisée par démontage assisté par laser.

Avantageusement, le substrat d'intérêt a une surface dont la plus grande dimension est inférieure d'au moins 200µm, de préférence d'au moins 500 µm, et encore plus préférentiellement d'au moins 1cm, à la plus grande dimension de la surface du premier substrat temporaire et/ou à la plus grande dimension de la surface du deuxième substrat temporaire.

Typiquement, les substrats sont des tranches ou 'wafers' (i.e. des plaques circulaires) et la plus grande dimension correspond au diamètre. La bande latérale a alors la forme d'un anneau.

Il est possible de réduire les dimensions du substrat d'intérêt au cours du procédé (par exemple après l'étape a).

Avantageusement, une couche de démontage est positionnée entre l'adhésif thermoplastique et le premier substrat temporaire et/ou entre le substrat d'intérêt et le deuxième substrat temporaire.

La couche de démontage est, de préférence, en un polymère fluoré, par exemple, un fluoroacrylate, ou en un composé organosilicié tel que l'octadécyltrichlorosilane ou le perfluorodécyltrichlorosilane.

Le procédé présente de nombreux avantages :
- être simple à mettre en oeuvre,
- pouvoir être mis en oeuvre pour de nombreux matériaux,
- pouvoir être mis en oeuvre pour un substrat d'intérêt de faible épaisseur (typiquement inférieure à 200 µm) et/ou pour un fort détourage (typiquement supérieur à 0,5 µm).

L'invention concerne également une structure constituée par successivement :
- un substrat d'intérêt, ayant une première face principale et une deuxième face principale,
- un adhésif thermoplastique, en regard de la première face principale du substrat d'intérêt,
- éventuellement, une couche de démontage, de préférence en un polymère fluoré ou en un composé organosilicié,
- un premier substrat temporaire,

le premier substrat temporaire ayant une surface supérieure à la surface du substrat d'intérêt,
l'adhésif thermoplastique formant une bande latérale autour du substrat d'intérêt.

D'autres caractéristiques et avantages de l'invention ressortiront du complément de description qui suit.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
Les figures 1A, 1B et 1C précédemment décrites, représentent, de manière schématique et en coupe, différentes étapes d'un procédé de collage temporaire selon l'art antérieur.
Les figures 2A à 2F représentent, de manière schématique et en coupe, différentes étapes d'un procédé de collage temporaire selon un mode de réalisation particulier de l'invention,
Les figures 3A à 3F représentent, de manière schématique et en coupe, différentes étapes d'un procédé de collage temporaire selon un autre mode de réalisation particulier de l'invention.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

En outre, dans la description ci-après, des termes qui dépendent de l'orientation, tels que « dessus », «dessous », etc. d'une structure s'appliquent en considérant que la structure est orientée de la façon illustrée sur les figures.

### EXPOSÉ DÉTAILLÉ DE MODES DE RÉALISATION PARTICULIERS

Bien que cela ne soit aucunement limitatif, l'invention trouve particulièrement des applications dans le domaine de la microélectronique. En particulier, l'invention est intéressante pour la fabrication de transistor, d'imageurs, de systèmes microélectromécaniques (ou MEMs pour 'MicroElectroMechanical Systems') ou de microphones.

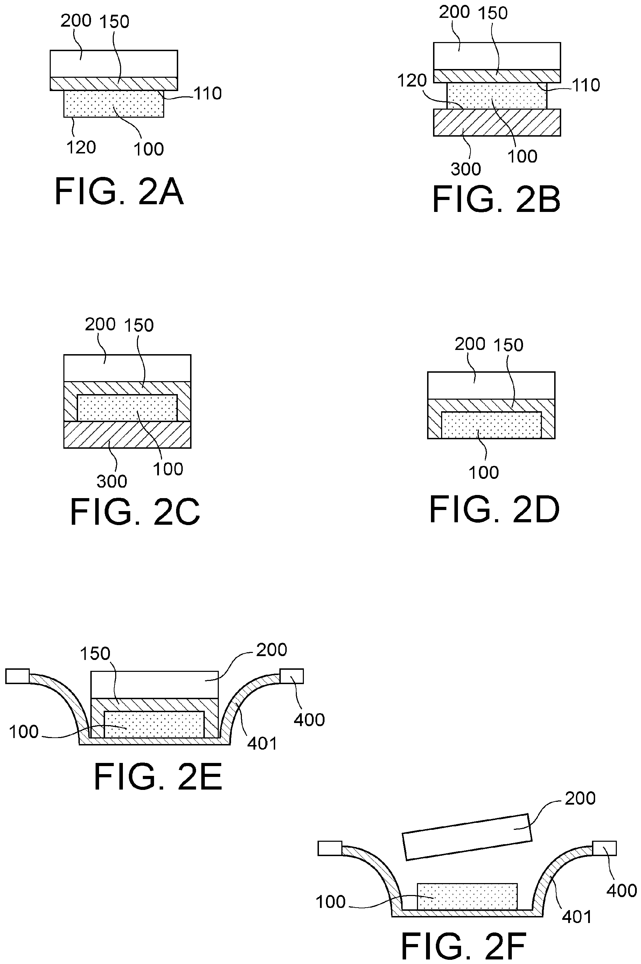

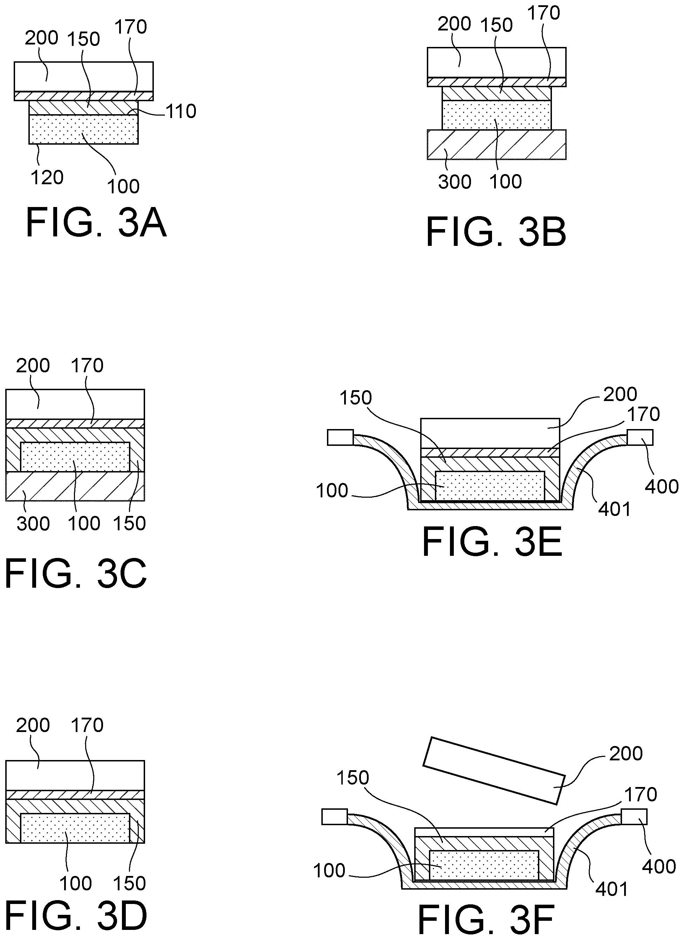

En faisant référence aux figures 2A à 2F ou aux figures 3A et 3F, nous allons maintenant décrire plus en détail différentes variantes d'un procédé de collage temporaire selon l'invention.

Le procédé de collage temporaire comprenant au moins les étapes suivantes :
a) fournir un empilement comprenant successivement (figure 2A ou figure 3A) :
   - un substrat d'intérêt 100, ayant une première face principale 110 et une deuxième face principale 120,
   - un adhésif thermoplastique 150, en regard de la première face principale 110 du substrat d'intérêt 100,
   - un premier substrat temporaire 200,
b) positionner un deuxième substrat temporaire 300 sur la deuxième face principale 120 du substrat d'intérêt 100, le premier substrat temporaire 200 et le deuxième substrat temporaire 300 ayant chacun une surface supérieure à la surface du substrat d'intérêt 100 (figure 2B ou figure 3B),
c) appliquer un traitement thermique à une température supérieure à la température de transition vitreuse de l'adhésif thermoplastique 150, éventuellement appliquer une force, moyennant quoi l'adhésif thermoplastique 150 forme une bande latérale autour du substrat d'intérêt 100 et adhère à la fois au premier substrat temporaire 200 et au deuxième substrat temporaire 300 (figure 2C ou figure 3C),
d) retirer le deuxième substrat temporaire 300 (figure 2D ou figure 3D),
e) fixer le substrat d'intérêt 100 sur un cadre 400, au moyen d'une feuille adhésive 401, la feuille adhésive 401 étant en contact avec la deuxième face principale 120 du substrat d'intérêt 100 (figure 2E ou figure 3E),
f) retirer le premier substrat temporaire 200 et l'adhésif thermoplastique 150 (figure 2F ou figure 3F).

L'étape a) peut être réalisée selon les sous-étapes suivantes :
- fixer un premier substrat temporaire 200 sur la première face principale 110 du substrat d'intérêt 100, au moyen d'un adhésif thermoplastique,
- éventuellement, réaliser un traitement thermique.

Le substrat d'intérêt 100 comprend une première face principale 110 ayant une première surface et une deuxième face principale 120 ayant une deuxième surface, parallèles ou sensiblement parallèles entre elles. Une face latérale d'une épaisseur e va de la première face principale 110 à la deuxième face principale 120 du substrat d'intérêt 100. La première surface de la première face principale 110 et la deuxième surface de la deuxième face principale 120 ont la même surface dite surface du substrat d'intérêt.

Le premier substrat temporaire 200 comprend une première face principale et une deuxième face principale. La première face principale du premier substrat temporaire est en regard de la première face principale 110 du substrat d'intérêt 100.

La première face principale 110 du substrat d'intérêt est, avantageusement, recouverte par des composants.

La fabrication de ces composants peut comporter par exemple des étapes de lithographie, de gravure ionique, de dépôts, de polissage, d'implantation. Sur une même face principale du substrat d'intérêt, les composants peuvent être identiques ou différents.

L'adhésif thermoplastique 150 est, par exemple, sous la forme d'un film adhésif.

L'adhésif thermoplastique 150 recouvre, de préférence, toute la surface de la première face 110 du substrat d'intérêt 100.

L'adhésif thermoplastique 150 est en un matériau thermoplastique. On choisira par exemple le produit Brewer 305 commercialisé par Brewer Science ou TOK zéro newton TWN12000 commercialisé par TOKYO OHKA KOGYO Co.

L'épaisseur du film adhésif 150 est, par exemple, comprise entre 1 µm et 200 µm et de préférence entre 20 µm et 100 µm. L'épaisseur du film adhésif dépend du volume délimité par la paroi latérale du substrat d'intérêt 100, le premier substrat temporaire 200 et le deuxième substrat temporaire 300.

Selon un mode de réalisation particulier, une couche de démontage 170 (aussi appelée couche de collage) peut être disposée entre l'adhésif thermoplastique 150 et le premier substrat temporaire 200 (figure 3A).

La couche de démontage 170 est destinée à faciliter le démontage du premier substrat. Elle peut être en un composé organosilicié ayant au moins un atome de chlore tel que l'octadécyltrichlorosilane (OTS), le perfluorodécyltrichlorosilane (FDTS), le perfluorodecyldimethylchlorosilane (FDDMCS).

Par composé organo-silicié, on entend un composé ayant au moins une liaison carbone-silicium.

La couche de démontage 170 peut être en un polymère fluoré, tel qu'un fluoroacrylate ou un polymère de type fluorosilane. On choisira par exemple les polymères fluorés commercialisés par la société 3M sous la référence Novec^{™} 2702, Novec^{™} 1700 ou Novec^{™} 1720 ou encore les polymères fluorés commercialisés par la société Daikin sous la référence Optool^{™}.

L'épaisseur de la couche de démontage 170 est, par exemple, comprise entre 1 nm et 1 µm et de préférence entre 5 nm et 100 nm.

Selon ce mode de réalisation particulier, lorsque la couche de démontage 170 est positionnée entre le premier substrat temporaire 200 et le substrat d'intérêt, l'étape a) du procédé peut comprendre les sous-étapes suivantes :
- déposer une couche de démontage 170 sur le premier substrat temporaire 200,
- positionner un adhésif thermoplastique 150 entre la première face principale 110 du substrat d'intérêt 100 et le premier substrat temporaire 200, et plus particulièrement entre la première face principale 110 du substrat d'intérêt 100 et la couche de démontage 170,
- réaliser un traitement thermique.

La couche de démontage 170 recouvre partiellement, et de préférence, recouvre totalement le premier substrat temporaire 200.

Entre l'étape a) et l'étape b), le procédé peut comprendre une étape au cours de laquelle on amincit le substrat d'intérêt 100 et/ou on fabrique des composants sur la deuxième face principale 120 du substrat d'intérêt 100. Les composants sur la deuxième face principale 120 peuvent être identiques ou différents de ceux présents sur la première face principale 110.

Lors de l'étape b), on positionne un deuxième substrat temporaire 300 sur la face exposé (deuxième face principale 120) du substrat d'intérêt 100.

Selon une variante de réalisation non représentée, une autre couche de démontage peut être positionnée entre le substrat d'intérêt 100 et le deuxième substrat temporaire 300.

Le deuxième substrat temporaire 300 comprend une première face principale et une deuxième face principale. La première face principale du deuxième substrat temporaire 300 est en regard de la deuxième face principale 120 du substrat d'intérêt 100.

Le substrat d'intérêt 100, le premier substrat temporaire 200 et le deuxième substrat temporaire 300 sont par exemple des plaques circulaires.

Le substrat d'intérêt 100 est en un premier matériau, le premier substrat temporaire 200 est un deuxième matériau et le deuxième substrat temporaire 300 est en un troisième matériau.

Le premier matériau, le deuxième matériau et le troisième matériau peuvent être identiques ou différents.

Le premier matériau, le deuxième matériau et le troisième matériau sont indépendamment choisis parmi les matériaux semi-conducteurs, par exemple le silicium ou le germanium, la silice, le verre, le saphir, les céramiques par exemple le SiC, les matériaux III-V comme AsGa, le GaN ou l'InP, les matériaux piézoélectriques comme LNO / LTO ou les métaux (par exemple molybdène, tungstène, titane, platine ou cuivre) ou les alliages. Par exemple, le premier matériau, le deuxième matériau et le troisième matériau peuvent être du silicium.

Le premier substrat temporaire 200 et le deuxième substrat temporaire 300 ont chacun une surface supérieure à la surface du substrat d'intérêt 100.

De préférence, le premier substrat temporaire 200 et le deuxième substrat temporaire 300 ont la même surface.

La largeur du détourage du substrat d'intérêt 100 est, avantageusement, supérieure ou égale à 200 µm, et de préférence supérieure ou égale à 500 µm. Le détourage dépend de la taille du substrat d'intérêt 100. Pour un substrat circulaire de 300mm de diamètre, on peut choisir par exemple un détourage de 1cm. Pour un substrat plus petit de 50 mm, un détourage compris entre 100µm et 1 mm convient.

Avantageusement, l'étape c) est réalisée en mettant en oeuvre un traitement thermique, moyennant quoi le film adhésif 150 devient visqueux, coule de part et d'autre du substrat d'intérêt 100 et forme une bande latérale autour du substrat d'intérêt 100 et adhère à la fois au premier substrat temporaire 200 et au deuxième substrat temporaire 300. A cette étape, on considère que la viscosité de l'adhésif thermoplastique doit être inférieure ou égale à 10⁴ Pa.s pour obtenir un bon fluage.

La bande latérale est continue depuis le premier substrat temporaire 200 jusqu'au deuxième substrat temporaire 300. La bande latérale est, de préférence, en contact avec la paroi latérale (aussi appelée flanc) du substrat d'intérêt 100. Alternativement, la bande latérale peut ne pas être en contact avec la paroi latérale du substrat d'intérêt 100 (i.e. un vide peut être présent entre la paroi latérale du substrat d'intérêt et la bande latérale).

Lors de l'étape c), on appliquera une température suffisamment élevée à l'assemblage. Notamment, on appliquera une température supérieure à la température de transition vitreuse Tg (par exemple une température T telle que T> Tg + 100°C), pour que l'adhésif devienne suffisamment fluide, flue et vienne combler l'espace détouré. Par exemple, on choisira, avantageusement, une température telle que la viscosité de l'adhésif est inférieure à 10⁴ Pa.s.

Avantageusement, on appliquera également une force suffisamment élevée. Par exemple, on pourra appliquer par exemple une force supérieure ou égale à 20kN dans le cas d'un substrat de 300 mm de diamètre et mettre en oeuvre une température supérieure ou égale à 200°C.

A l'issue de l'étape c), le film adhésif 150 forme une bande latérale autour du substrat d'intérêt 100 et adhère à la fois au premier substrat temporaire 200 et au deuxième substrat temporaire 300.

L'énergie d'adhérence E₁ entre le substrat d'intérêt 100 et le premier substrat temporaire 200 est supérieure à l'énergie d'adhérence E₂ entre le substrat d'intérêt 100 et le deuxième substrat temporaire 300.

L'adhérence E₃ entre les deux substrats temporaires. E₃ peut se décomposer en deux adhérences E₃₁ et E₃₂ respectivement entre le premier substrat temporaire et la bande adhésive et entre le deuxième substrat temporaire et la bande adhésive. L'énergie d'adhérence E₃₁ entre le premier substrat temporaire 200 et l'adhésif est supérieure à l'énergie d'adhérence E₃₂ entre le deuxième substrat temporaire 300 et l'adhésif.

Lors de l'étape d), le deuxième substrat temporaire 300 est séparé de la structure comprenant le substrat d'intérêt 100, l'adhésif thermoplastique 150, éventuellement la couche de démontage 170, et le premier substrat temporaire 200.

Lors de l'étape e), on monte cette structure sur un cadre 400 au moyen d'une feuille adhésive (ou film adhésif) 401. Aucun contact n'est possible entre la feuille adhésive 401 et le premier substrat temporaire 200. Le cadre 400 est, par exemple, un cadre circulaire.

Le cadre 400 peut être un cadre métallique, par exemple de type 'DISCO'.

La couche adhésive 401, utilisée lors de l'étape e), permettant de maintenir l'empilement au cadre 400, est, par exemple, une couche acrylique.

L'épaisseur de la couche adhésive 401 est, par exemple, comprise entre 50 µm et 150 µm.

La face de la couche adhésive 401, qui n'est pas en contact avec l'assemblage, peut être recouverte par un film non adhésif, par exemple en polyéthylène téréphtalate (PET) ou en polypropylène.

On choisira par exemple une couche adhésive 401 commercialisée par la société Furukawa^{®} sous la référence SP-537T-230.

Lors de l'étape f), on retire le premier substrat temporaire 200 et l'adhésif thermoplastique 150. Le cas échéant, on retire également la couche de démontage 170.

L'adhésif thermoplastique 150 peut être retiré par un nettoyage au moyen d'un solvant adapté. Le solvant est par exemple choisi parmi les alcools et les hydrocarbures, ou un de leurs mélanges. A titre illustratif, on peut choisir un premier nettoyage à base de D-limonène suivi d'un rinçage à base d'alcool isopropylique (aussi appelé propan-2-ol). Il est également possible d'utiliser du mésitylène.

Nous allons maintenant décrire plus en détail trois variantes de réalisation pouvant être mises en oeuvre.

Selon une première variante de réalisation, la température de fluage de l'adhésif thermoplastique 150 est inférieure à 250°C, voire inférieure à 200°C. On pourra alors utiliser un deuxième substrat temporaire 300 en un composé organique antiadhésif, par exemple en polymère fluoré, de préférence en polytétrafluoroéthylène (aussi connu sous la référence commerciale Téflon^{®}) ou en polyimide (également connu sous la référence commerciale Kapton^{®}). Alternativement, il est possible d'utiliser un deuxième substrat temporaire 300, par exemple, une plaque de silicium, recouvert par une couche antiadhésive, par exemple en polytétrafluoroéthylène ou en polyimide. L'étape c) est alors réalisée au moyen d'une thermocompression.

Selon cette première variante de réalisation, l'étape d) peut être réalisée en retirant juste le deuxième substrat temporaire 300 par un démontage mécanique. Si le deuxième substrat temporaire 300 comprend une couche antiadhésive, celle-ci peut être retirée par pelage.

Selon une deuxième variante de réalisation, la température de fluage de l'adhésif thermoplastique est inférieure à 200°C, voire inférieure à 200°C. L'étape b) est, avantageusement, réalisée au moyen d'un collage direct, par exemple de type Si/SiO₂. L'étape c) est réalisée au moyen d'une thermocompression.

Selon cette deuxième variante de réalisation, l'étape d) peut être réalisée par rodage mécanique et attaque chimique.

De préférence, le deuxième substrat 300 temporaire est en silicium. On peut alors, par exemple, utiliser une première solution d'attaque chimique HF/HNO₃ pour le silicium puis une deuxième solution d'attaque chimique à base de HF.

On choisira, par exemple, un premier substrat temporaire 200 en verre.

Selon une troisième variante de réalisation, le deuxième substrat temporaire 300 est en verre et il est recouvert par une couche de démontage sensible au rayonnement laser. On utilisera, par exemple, une couche de démontage en Brewer bond 701. L'étape c) est alors réalisée par thermocompression, moyennant quoi le substrat d'intérêt 100 et le deuxième substrat temporaire 300 sont fixés l'un à l'autre. La température de la thermocompression dépend de la résistance de la couche de démontage et de la température de fluage de l'adhésif.

Selon cette troisième variante de réalisation, l'étape d) peut être réalisée en retirant la plaque de verre 300 par un démontage assisté par Laser.

### Exemples illustratifs et non limitatifs d'un mode de réalisation :

Nous allons maintenant décrire plus en détail différents exemples de réalisation.

### Exemple 1: 1ère variante de réalisation : deuxième substrat temporaire 300 en un composé organique antiadhésif (Teflon^{®}) :

On utilise des plaques de silicium de 200 mm de diamètre comme substrat d'intérêt 100 et comme premier substrat temporaire 200.

Sur le premier substrat temporaire 200 en silicium, on étale une couche de démontage 170. Il s'agit d'un film de Novec^{™} 2702 et on recuit l'ensemble à 150°C pendant 30 min.

Au moyen d'une scie diamantée, on détoure le substrat d'intérêt 100 en silicium sur une largeur de 1,5 mm et une profondeur de 200 µm. On étale 40 µm d'un adhésif thermoplastique 150 sur cette plaque 100. Il s'agit d'une résine adhésive Brewer 305. On vient coller cet ensemble à 210°C avec le premier substrat temporaire 200 de façon à créer une interface entre l'adhésif thermoplastique 150 et la couche de démontage 170.

On amincit par abrasion mécanique au moyen d'une roue diamantée le substrat d'intérêt 100 à 20 µm. La surface du substrat d'intérêt 100 subit un nettoyage par voie humide. Puis on monte l'ensemble sur un cadre 400 métallique 'DISCO' au moyen d'une feuille adhésive 401 Furukawa^{®} SP-537T-230. La feuille adhésive 401 contacte le premier substrat temporaire 200 et le démontage mécanique de ce substrat temporaire 200 est impossible.

De façon alternative, on colle par thermocompression un deuxième substrat temporaire 300 de Téflon de 200 mm de diamètre et 3 mm d'épaisseur avec le substrat d'intérêt 100. Le collage est réalisé à 200°C sous une force de 20 kN. En insérant un coin dans cet empilement, on démonte ensuite le deuxième substrat temporaire 300.

On monte l'ensemble sur un cadre 400 métallique 'DISCO' au moyen d'une feuille adhésive 401 Furukawa^{®} SP-537T-230. La feuille adhésive 401 ne contacte pas le premier substrat temporaire 200 et le démontage mécanique de ce substrat temporaire 200 est possible. La résine adhésive Brewer 305 est retirée par un nettoyage à base de D-limonene et d'isopropanol.

### Exemple 2 : 1ère variante de réalisation : deuxième substrat temporaire 300 recouvert par une couche de polymère fluoré :

Les substrats temporaires 200 et 300 ainsi que le substrat d'intérêt 100 sont des plaques de silicium de 200 mm de diamètre.

Sur le premier substrat temporaire 200, on étale une couche de démontage 170 (film de Novec^{™} 2702) et on recuit l'ensemble à 150°C pendant 30 min.

Au moyen d'une scie diamantée, on détoure le substrat d'intérêt sur une largeur de 1,5 mm et une profondeur de 200 µm. On étale 40 µm d'un adhésif thermoplastique 150 (résine adhésive Brewer 305) sur le substrat d'intérêt 100 et on vient coller cet ensemble à 210°C avec le premier substrat temporaire 200 de façon à créer une interface entre l'adhésif thermoplastique 150 et la couche de démontage.

On amincit par abrasion mécanique au moyen d'une roue diamantée le substrat d'intérêt 100 à 20 µm. La surface du substrat d'intérêt 100 subit un nettoyage par voie humide. On étale un film fluoré de Optool^{™} DAIKIN sur le deuxième substrat temporaire 300. On colle par thermocompression le deuxième substrat temporaire 300 avec le premier substrat temporaire 200 de façon à créer une interface entre le film d'Optool^{™} et la surface du substrat d'intérêt 100. Le collage est réalisé à 200°C sous une force de 20 kN. En insérant un coin dans cet empilement, on démonte le deuxième substrat temporaire 300.

On monte l'ensemble sur un cadre 400 métallique 'DISCO' au moyen d'un film adhésif 401 Furukawa^{®} SP-537T-230. Le film adhésif 401 ne contacte pas le premier substrat temporaire 200 et le démontage mécanique de ce substrat temporaire est possible. La résine adhésive Brewer 305 est retirée par un nettoyage à base de D-limonene et d'isopropanol.

### Exemple 3 : 1ère variante de réalisation : deuxième substrat temporaire 300 recouvert par un composé organique antiadhésif de type Kapton^{®} :

On utilise pour les substrats temporaires 200 et 300 ainsi que pour le substrat d'intérêt 100 des plaques de silicium de 200 mm de diamètre.

Sur le premier substrat temporaire 200, on étale une couche de démontage 170 (film de Novec^{™} 2702) et on recuit l'ensemble à 150°C pendant 30 min.

Au moyen d'une scie diamantée, on détoure le substrat temporaire 100 sur une largeur de 1,5 mm et une profondeur de 200 µm. On étale 40 µm d'un adhésif thermoplastique 150 (résine adhésive Brewer 305) sur cette plaque et on vient coller cet ensemble à 210°C avec le premier substrat temporaire 200 de façon à créer une interface entre l'adhésif thermoplastique 150 et la couche de démontage 170.

On amincit par abrasion mécanique au moyen d'une roue diamantée le substrat d'intérêt 100 à 20 µm. La surface de ce substrat subit un nettoyage par voie humide.

On réalise un collage par thermocompression de l'empilement suivant : le deuxième substrat temporaire 300 / une feuille de Kapton^{®} (Upilex 25S) / le substrat d'intérêt 100 / l'adhésif thermoplastique 150 / la couche de démontage / le premier substrat temporaire 200. On réalise une interface entre le substrat d'intérêt 100 et la feuille Upilex. Le collage est réalisé à 200°C sous une force de 20 kN. En insérant un coin dans cet empilement, on démonte le deuxième substrat temporaire 300 et on vient peler la feuille Upilex du substrat d'intérêt 100.

On monte l'ensemble sur un cadre métallique 'DISCO' 400 au moyen d'un film adhésif 401 Furukawa^{®} SP-537T-230. Le film adhésif ne contacte pas le premier substrat temporaire 200 et le démontage mécanique de ce substrat temporaire est possible. La résine adhésive Brewer 305 est retirée par un nettoyage à base de D-limonene et d'isopropanol.

### Exemple 4 : 2ème variante de réalisation : deuxième substrat temporaire 300 en silicium assemblé par collage direct au substrat d'intérêt 100 :

On utilise pour le substrat d'intérêt 100 et le deuxième substrat temporaire 200 sont des plaques de silicium de 200 mm de diamètre.

Au moyen d'une scie diamantée, on détoure le substrat d'intérêt 100 sur une largeur de 0.5 mm et une profondeur de 200 µm. On étale 20 µm d'adhésif thermoplastique 150 (résine adhésive HD3007) sur cette plaque 100 et on vient coller cet ensemble à 350°C avec un premier substrat temporaire 200. Le premier substrat temporaire 200 est une plaque de verre.

On amincit par abrasion mécanique au moyen d'une roue diamantée le substrat d'intérêt 100 à 20 µm. La surface de ce substrat d'intérêt 100 subit un nettoyage par voie humide et un polissage mécano chimique.

On oxyde une plaque de silicium (deuxième substrat temporaire 300) de façon à former en surface un film de SiOz de 400 nm. Un collage direct Si/SiO₂ est réalisé entre le deuxième substrat temporaire 300 et la face polie du substrat d'intérêt 100. Cet empilement subit un recuit à 380°C sous une force de 10 kN. Par abrasion mécanique, on réduit l'épaisseur du deuxième substrat temporaire 300 à 50 µm. On vient ensuite graver le silicium restant par une solution de HF/HNO₃, la couche de SiOz de 400 nm constitue une couche d'arrêt à la gravure du silicium. Cette couche de SiO₂ est retirée par gravure à base de HF. Cette gravure s'arrête sur le silicium du substrat d'intérêt 100 et sur l'adhésif thermoplastique 150 (résine HD3007).

On monte l'ensemble sur un cadre 400 métallique 'DISCO' au moyen d'un film adhésif 401 Furukawa^{®} SP-537T-230. On irradie le premier substrat temporaire 200 en verre au moyen d'un laser 248 nm. Ce traitement dégrade l'interface entre le verre et l'adhésif HD3007. Le film adhésif 401 ne contacte pas le deuxième substrat temporaire 200 et le démontage mécanique de ce substrat temporaire 200 est possible. La résine adhésive HD3007 est retirée par un nettoyage à base de EKC865.

### Exemple 5 : 3ème variante de réalisation : deuxième substrat temporaire 300 en verre recouvert par une couche sensible au rayonnement laser :

On utilise pour le premier substrat temporaire 200 ainsi que pour le substrat d'intérêt 100 des plaques de silicium de 300 mm de diamètre.

Sur le premier substrat temporaire 200 en silicium, on étale une couche de démontage 170 : un film de OTS (octadecyltrichlorosilane) en solution dans l'isooctane.

Au moyen d'une scie diamantée, on détoure le substrat d'intérêt 100 en silicium sur une largeur de 0,5 mm et une profondeur de 200 µm. On étale sur le substrat d'intérêt 100 un film adhésif thermoplastique 150 TOK zéro newton TWM12000 de 100 µm et on vient coller cet ensemble à 180°C avec le premier substrat temporaire 200.

On amincit par abrasion mécanique au moyen d'une roue diamantée le substrat d'intérêt 100 à 50 µm. La surface du substrat d'intérêt 100 subit un nettoyage par voie humide.

On étale une autre couche adhésive (80 nm d'une couche de Brewer bond 701) sur le deuxième substrat temporaire 300. Le deuxième substrat temporaire 300 est une plaque en verre. On réalise un collage par thermocompression entre la surface du substrat d'intérêt 100 et du deuxième substrat temporaire 300. Le collage est réalisé à 240°C sous une force de 15 kN. On irradie le deuxième substrat temporaire 300 en verre au moyen d'un laser 355 nm. Ce traitement dégrade l'interface entre le verre et la couche Brewer Bond 701. On démonte mécaniquement le deuxième substrat temporaire 300.

On monte l'ensemble sur un cadre 400 métallique 'DISCO' au moyen d'un film adhésif Furukawa^{®} SP-537T-230. Le film adhésif ne contacte pas le premier substrat temporaire 200 et le démontage mécanique de ce substrat 200 est possible. La résine adhésive TOK est retirée par un nettoyage à base de mésitylène.

## Revendications

1. Procédé de collage temporaire comprenant les étapes suivantes :
a) fournir un empilement comprenant successivement :
- un substrat d'intérêt (100), ayant une première face principale (110) et une deuxième face principale (120),
- un adhésif thermoplastique (150), en regard de la première face principale (110) du substrat d'intérêt (100),
- un premier substrat temporaire (200),
b) positionner un deuxième substrat temporaire (300) en regard de la deuxième face principale (120) du substrat d'intérêt (100), le premier substrat temporaire (200) et le deuxième substrat temporaire (300) ayant chacun une surface supérieure à la surface du substrat d'intérêt (100),
c) appliquer un traitement thermique à une température supérieure à la température de transition vitreuse de l'adhésif thermoplastique (150), moyennant quoi l'adhésif thermoplastique (150) forme une bande latérale autour du substrat d'intérêt (100) et adhère à la fois au premier substrat temporaire (200) et au deuxième substrat temporaire (300), avantageusement une force est appliquée lors de l'étape c),
d) retirer le deuxième substrat temporaire (300),
e) fixer le substrat d'intérêt (100) sur un cadre (400), au moyen d'une feuille adhésive (401), la feuille adhésive (401), étant en contact avec la deuxième face principale (120) du substrat d'intérêt (100),
f) retirer le premier substrat temporaire (200) et l'adhésif thermoplastique (150).

2. Procédé selon la revendication 1, **caractérisé en ce que** la température de transition vitreuse de l'adhésif thermoplastique (150) est inférieure à 250°C, et de préférence inférieure à 200°C.

3. Procédé selon la revendication 2, **caractérisé en ce que** le deuxième substrat temporaire (300) est en polytétrafluoroéthylène ou en polyimide ou **en ce que** le deuxième substrat temporaire (300) est recouvert d'une couche polymère de polytétrafluoroéthylène ou de polyimide.

4. Procédé selon les revendications 2 et 3, **caractérisé en ce que** l'étape d) est réalisée par une action mécanique, et le cas échéant la couche de polymère recouvrant le deuxième substrat temporaire (300) est retirée par pelage.

5. Procédé selon la revendication 1, **caractérisé en ce que** la température de transition vitreuse de l'adhésif thermoplastique (150) est supérieure à 200°C, de préférence supérieure à 250°C et **en ce que** l'étape b) est réalisée par collage direct.

6. Procédé selon la revendication 5, **caractérisé en ce que** l'étape d) est réalisée par rodage mécanique et attaque chimique.

7. Procédé selon la revendication 1, **caractérisé en ce que** le deuxième substrat temporaire (300) est en verre et **en ce qu'**il est recouvert par une couche de démontage sensible au laser.

8. Procédé selon la revendication 7, **caractérisé en ce que** l'étape d) est réalisée par démontage assisté par laser.

9. Procédé selon l'une quelconque des revendications précédentes, **caractérisé en ce que**, lors de l'étape c), on applique une thermocompression.

10. Procédé selon l'une quelconque des revendications précédentes, **caractérisé en ce que** le substrat d'intérêt (100) a une surface dont la plus grande dimension est inférieure d'au moins 200µm, de préférence d'au moins 500 µm, à la plus grande dimension de la surface du premier substrat temporaire (200) et/ou à la plus grande dimension de la surface du deuxième substrat temporaire (300).

11. Procédé selon l'une quelconque des revendications précédentes, **caractérisé en ce qu'**une couche de démontage (170), de préférence en un polymère fluoré ou en un composé organosilicié, est positionnée entre l'adhésif thermoplastique (150) et le premier substrat temporaire (200) et/ou entre le substrat d'intérêt (100) et le deuxième substrat temporaire (300).

12. Structure constituée par successivement :
- un substrat d'intérêt (100),
- un adhésif thermoplastique (150),
- éventuellement, une couche de démontage (170), de préférence en un polymère fluoré ou en un composé organosilicié,
- un premier substrat temporaire (200),
**caractérisé en ce que** le premier substrat temporaire (200) a une surface supérieure à la surface du substrat d'intérêt (100),
et **en ce que** l'adhésif thermoplastique (150) forme une bande latérale autour du substrat d'intérêt (100).

13. Structure selon la revendication 12, **caractérisée en ce que** le substrat d'intérêt (100) est en un matériau choisi parmi les matériaux semi-conducteurs, la silice, le verre, le saphir, les céramiques, les matériaux III-V, les matériaux piézoélectriques, les métaux ou les alliages.
